# EUROPEAN PATENT APPLICATION

(11) **EP 4 450 316 A1**
(43) Date of publication of application: **23.10.2024**
(21) Application number: 22906004.1
(22) Date of filing: 30.09.2022
(51) Int. Cl.: B60L 3/00

(54) **HIGH-VOLTAGE INPUT UNDER-VOLTAGE FAULT DETECTION METHOD AND APPARATUS FOR ELECTRIC VEHICLE, AND STORAGE MEDIUM**

(30) Priority: 13.12.2021 CN 202111517207
(71) Applicant: Guangzhou Automobile Group Co. Ltd., Guangzhou, Guangdong 510030 (CN)
(72) Inventor: QIU, Lin, Guangzhou, Guangdong 511434 (CN); YI, Chen, Guangzhou, Guangdong 511434 (CN); LI, Ronghua, Guangzhou, Guangdong 511434 (CN); JIANG, Hai, Guangzhou, Guangdong 511434 (CN); XU, Hongda, Guangzhou, Guangdong 511434 (CN)
(74) Representative: Zaboliene, Reda
(86) International application number: PCT/CN2022/123033
(87) International publication number: WO 2023/109252

(57) **Abstract**

The present application discloses a high-voltage input under-voltage fault detection method for an electric vehicle, a device and a computer storage medium. The method includes obtaining an internal voltage of a target component of the electric vehicle after detecting that a battery pack of the electric vehicle is powered on with the high voltage and before the target component is powered on with the high voltage, and determining whether the internal voltage is less than or equal to a preset voltage value. If yes, the method determines that the target component has the undervoltage fault for high voltage input. In this way, after the battery pack of the electric vehicle is powered on with the high voltage and before the target component is powered on with the high voltage, it can accurately detect whether the target component has an undervoltage fault for high voltage input, which solves the problem in the prior art that the undervoltage fault can only be detected when the target component is in the working state, improves the convenience of management and maintenance of the electric vehicle, and improves the user experience.

## Description

The present application claims the benefit and priority of Chinese patent application submitted to the China Patent Office on December 13, 2021, with application number 202111517207.2, entitled "HIGH-VOLTAGE INPUT UNDER-VOLTAGE FAULT DETECTION METHOD AND APPARATUS FOR ELECTRIC VEHICLE, AND STORAGE MEDIUM" the content of which is hereby incorporated fully by reference herein into the present disclosure.

### FIELD

The present disclosure relates to a field of electric vehicles, especially relates to a high-voltage input under-voltage fault detection method and apparatus for an electric vehicle, and a storage medium.

### BACKGROUND

Driving pure electric vehicles is realized by a motor controller driving a motor through a high voltage. When the high voltage inputs to the motor controller fail, the motor will not run. However, the motor controller is triggered to detect the undervoltage fault for high voltage input only after the motor controller is powered on with the high voltage and the motor controller is operated normally. Therefore, during a process that a high voltage battery pack of the vehicle is not electrified by a high voltage to the battery pack is powered on with the high voltage of the high voltage, it is impossible to detect an undervoltage fault for high voltage input for the motor controller already existed.

### SUMMARY

The present application is aim to provide a high-voltage input under-voltage fault detection method and apparatus for an electric vehicle, and a computer storage medium, which improves convenience of management and maintenance of electric vehicles and improves user experience.

To achieve the aforementioned aim, technical solution of the present disclosure is achieved in that way:
In first aspect, an embodiment of the present disclosure provides a high-voltage input under-voltage fault detection method for an electric vehicle, the method comprising:
obtaining an internal voltage of a target component of the electric vehicle after detecting that a battery pack of the electric vehicle is powered on with the high voltage and before the target component is powered on with the high voltage;
determining whether the internal voltage is less than or equal to a preset voltage value;
if yes, determining that the target component has the undervoltage fault for high voltage input.

As one of the implementation manners, before obtaining the internal voltage of the target component of the electric vehicle after detecting that the battery pack of the electric vehicle is powered on with the high voltage and before the target component is powered on with the high voltage, the method further comprises:
detecting whether the main positive relay of the battery pack is in a closed state;
if yes, determining that the battery pack of the electric vehicle is powered on with the high voltage; and
if no, determining that the battery pack of the electric vehicle is not powered on with the high voltage.

As one of the implementation manners, the detecting whether the main positive relay of the battery pack is in the closed state comprises:
receiving a state signal of the main positive relay of the battery pack sent by a battery management system; and
detecting whether the main positive relay of the battery pack is in the closed state according to the state signal.

As one of the implementation manners, before the determining that the battery pack of the electric vehicle is powered on with the high voltage, the method further comprises:
receiving an external voltage value of the battery pack sent by a battery management system;
detecting whether the external voltage value of the battery pack is greater than the preset voltage value;
if yes, performing a step of the determining that the battery pack of the electric vehicle is powered on with the high voltage; and
if no, performing a step of the determining that the battery pack of the electric vehicle is not powered on with the high voltage.

As one of the implementation manners, the obtaining the internal voltage of the target component of the electric vehicle comprises:
obtaining the internal voltage of the target component after detecting that the battery pack of the electric vehicle has been power on with the high voltage for a preset period of time.

As one of the implementation manners, after determining that the target component has the undervoltage fault for high voltage input, the method further comprises:
outputting a prompt message that the target component has the undervoltage fault for high voltage input.

As one of the implementation manners, a prompting manner of the prompt message comprises at least one of text, voice, and light.

As one of the implementation manners, the method further comprising:
continuing to detect and determine whether the internal voltage of the target component is less than or equal to the preset voltage value after determining that the target component is powered on with the high voltage and enters a working state.

In second aspect, an embodiment of the present disclosure provides a high-voltage input under-voltage fault detection device for an electric vehicle, wherein the device comprises at least one process and a storage device for storing programs, the programs are used for executing steps of the method for detecting undervoltage fault for high voltage input for an electric vehicle when the programs being executed by at least one processor.

In third aspect, an embodiment of the present disclosure provides a computer readable storage medium where computer programs are stored herein, the computer programs are used for executing steps of a high-voltage input under-voltage fault detection method for an electric vehicle when the computer programs being executed by at least one processor.

An embodiment of the present invention provides a high-voltage input under-voltage fault detection method for an electric vehicle, a device and a computer storage medium. The method includes obtaining an internal voltage of a target component of the electric vehicle after detecting that a battery pack of the electric vehicle is powered on with the high voltage and before the target component is powered on with the high voltage, and determining whether the internal voltage is less than or equal to a preset voltage value. If yes, the method determines that the target component has the undervoltage fault for high voltage input. In this way, after the battery pack of the electric vehicle is powered on with the high voltage and before the target component is powered on with the high voltage, it can accurately detect whether the target component has an undervoltage fault for high voltage input, which solves the problem in the prior art that the undervoltage fault can only be detected when the target component is in the working state, improves the convenience of management and maintenance of the electric vehicle, and improves the user experience.

### BRIEF DESCRIPTION OF THE DRAWINGS

FIG. 1 is a flowchart of a high-voltage input under-voltage fault detection method for an electric vehicle provided by an embodiment of the present disclosure.
FIG. 2 is a structural schematic diagram of an existing high voltage system of an electric vehicle.
FIG. 3 is a schematic diagram of an interactive process of high voltage electricity on the existing electric vehicle.
FIG. 4 is a detailed flowchart of a high-voltage input under-voltage fault detection method for an electric vehicle provided by an embodiment of the present disclosure.
FIG. 5 is a schematic structural diagram of a high-voltage input under-voltage fault detection device for an electric vehicle provided by an embodiment of the present disclosure.

### DETAILED DESCRIPTION

It should be noted that, in the present disclosure, the term "comprising", "including" or any other variation thereof is intended to cover a non-exclusive inclusion such that a process, method, article or apparatus comprising a set of elements includes not only the set of elements, also includes other elements not expressly listed, or elements inherent in the process, method, article, or apparatus. Without further limitations, an element defined by the phrase "comprising a..." does not preclude the presence of other identical elements in the process, method, article, or apparatus that includes the element. In addition, components, features, and elements of different embodiments of the present disclosure with the same name may have the same meaning, or may have different meanings, and the specific meaning shall be determined based on the explanation in the specific embodiment or further combined with the present disclosure in the specific embodiment.

It should be understood that although the terms first, second, third, etc. may be used herein to describe various information, the information should not be limited to these terms. These terms are only used to distinguish information of the same type from one another. For example, without departing from a scope of the present disclosure, first information may also be called second information, and similarly, second information may also be called first information. Depending on the present disclosure, the word "if" as used herein may be interpreted as "at" or "when" or "in response to a determination." Furthermore, as used herein, the singular forms "a", "an" and "the" are intended to include plural forms as well, unless the present disclosure indicates otherwise. It should be further understood that the terms "comprising", "including" indicate the presence of stated features, Steps, operations, elements, components, items, species, and/or groups, but do not exclude one or more other features, Steps, operations, The existence, occurrence or addition of an element, component, item, species, and/or group. The terms "or" and "and/or" as used herein are to be construed as inclusive, or to mean either one or any combination. Thus, "A, B or C" or "A, B and/or C" means "any of the following: A; B; C; A and B; A and C; B and C; A, B and C." Exceptions to this definition will only arise when combinations of elements, functions, Steps or operations are inherently mutually exclusive in some way.

It should be understood that although the various Steps in the flowchart in the embodiment of the present disclosure are displayed sequentially as indicated by arrows, these Steps are not necessarily executed sequentially in the order indicated by the arrows. Unless otherwise specified herein, there is no strict order restriction on the execution of these Steps, and they can be executed in other orders. Moreover, at least some of the Steps in the flowchart may include multiple sub-Steps or multiple stages, these sub-Steps or stages are not necessarily executed at the same time, but may be executed at different times, and an execution order is not necessarily sequential instead, it may be performed alternately or alternately with at least a part of other Steps or sub-Steps or stages of other steps.

It should be noted that, in the present disclosure, Steps such as S101 and S 102 are used, the purpose of which is to express corresponding content more clearly and concisely, and does not constitute a substantive limitation on the order. Those skilled in the art may, during specific implementation, S102 will be executed first and then execute S101 and so on, but these should all be within a protection scope of the present disclosure.

It should be understood that the specific embodiments described here are only used to explain the present disclosure and are not intended to limit the present disclosure. The technical solution of the present disclosure will be further described in detail below in conjunction with the accompanying drawings and specific embodiments. Unless otherwise defined, all technical and scientific terms used herein have the same meaning as commonly understood by one of ordinary skill in the technical field of the invention. The terms used herein in the description of the present disclosure are for the purpose of describing specific embodiments only, and are not intended to limit the present disclosure. As used herein, the term "and/or" includes any and all combinations of one or more of the associated listed items.

Referring to FIG. 1, shows a flowchart of one embodiment of a high-voltage input under-voltage fault detection method for an electric vehicle provided by an embodiment of the present disclosure, and the method can be executed by an undervoltage fault detection device for high voltage input for an electric vehicle provided by an embodiment of the present disclosure. The undervoltage fault detection device for high voltage input for the electric vehicle can be realized by software and/or hardware. Optionally, the undervoltage fault detection device for high voltage input for the electric vehicle can be specifically an electric vehicle, or target component such as a motor controller, a DC/DC power supply, an on-board charger and so on, the method comprises the following steps:

Step S 101, obtaining an internal voltage of the target component after detecting that a battery pack of the electric vehicle is powered on with the high voltage and before the target component is powered on with the high voltage.

It should be noted that when the target components are different, an execution body of the method for detecting the undervoltage fault for the high voltage input for the electric vehicle is also different. That is, the target component obtains the internal voltage of the target component after detecting that a battery pack of the electric vehicle is powered on with the high voltage and before the target component is powered on with the high voltage. Optionally, the target component can detect whether the battery pack of the electric vehicle is powered on with the high voltage through a state of a main positive relay of the battery pack of the electric vehicle.

In one embodiment, before obtaining the internal voltage of the target component after detecting that the battery pack of the electric vehicle is powered on with the high voltage and before the target component is powered on with the high voltage, the method further includes:

Detecting whether the main positive relay of the battery pack is in a closed state,
If yes, it is determined that the battery pack of the electric vehicle is powered on with the high voltage.

If no, it is determined that the battery pack of the electric vehicle is not powered on with the high voltage.

In one embodiment, the method detects whether the main positive relay of the battery pack is in a closed state by receiving a state signal of the main positive relay of the battery pack sent by a battery management system and detecting whether the main positive relay of the battery pack is in the closed state according to the state signal. Understandably, after a user turns an ignition key of the electric vehicle to a KEY-ON gear, the vehicle controller of the electric vehicle will send an instruction to close the main positive relay of the battery pack to the battery management system to turn on a high voltage circuit. After receiving the instruction sent by the vehicle controller, the battery management system will drive the main positive relay to close to power on the battery pack with the high voltage. And at the same time the battery management system will send a closed state signal of the main positive relay of the battery pack and an external voltage value signal of the battery pack to the target component. When the target component receives the state signal of the main positive relay of the battery pack sent by the battery management system, if it detects that the state signal is the closed state signal, then it is determined that the main positive relay of the battery pack is in the closed state, otherwise it is determined that the battery pack is not in the closed state. Here, if the target component detects that the main positive relay of the battery pack is in the closed state, it can be determined that the battery pack of the electric vehicle is powered on with the high voltage. If the target component detects that the main positive relay of the battery pack is not in the closed state, it can be determined that the battery pack of the electric vehicle is not powered on with the high voltage.

In addition, before determining that the battery pack of the electric vehicle is powered on with the high voltage, the method further includes:
Receiving an external voltage value of the battery pack sent by the battery management system,
Detecting whether the external voltage value of the battery pack is greater than a preset voltage value,
If yes, then perform a step of determining that the battery pack of the electric vehicle is powered on with the high voltage.

If no, perform a step of determining that the battery pack of the electric vehicle is not powered on with the high voltage.

It can be understood that after detecting that the main positive relay of the battery pack is in the closed state, the method can continue to detect whether the external voltage value of the battery pack is greater than the preset voltage value, if the voltage value external the pack of the battery pack is greater than the preset voltage value, it is determined that the battery pack of the electric vehicle is powered on with the high voltage, that is, the battery pack is powered on with the high voltage successful. If the external voltage value of the battery pack is less than or equal to the preset voltage value, it is determined that the battery pack of the electric vehicle is not powered on with the high voltage, that is, the battery pack being powered on with the high voltage fails. The preset voltage value can be set according to actual needs, for example, according to an output voltage of the battery pack. It should be noted that, in order to avoid design redundancy, after detecting that the main positive relay of the battery pack is in the closed state, it is also necessary to detect whether the external voltage value of the battery pack is greater than the preset voltage value. If so, the main positive relay of the battery pack is really closed, and the high voltage is valid.

In one embodiment, the method obtains the internal voltage of the target component includes:
Obtaining the internal voltage of the target component after detecting that the battery pack of the electric vehicle has been power on with the high voltage for a preset period of time.

It is understandable that after the battery pack of the electric vehicle is powered on with the high voltage, it may take a certain period of time before the target component can be fully powered on with the high voltage. After a preset period of time, the internal voltage of the target component is obtained, so as to improve an accuracy of the internal voltage of the target component. The preset period of time can be set according to an actual situation, for example, it can be set to 0.5 second, 1 second and so on.

Step S102, determining whether the internal voltage is less than or equal to a preset voltage value.

In one embodiment, the preset voltage value can be set according to actual needs. For example, the preset voltage value can be set according to an output voltage of the battery pack. For example, the preset voltage value can be set to 180V or the like.

Step S103, if yes, determining that the target component has the undervoltage fault for high voltage input.

Specifically, in a condition that the internal voltage of the target component is less than or equal to the preset voltage value after the battery pack of the electric vehicle is powered on with the high voltage and before the target component is powered on with the high voltage, it is determined that the target component has the undervoltage fault for high voltage input.

To sum up, in the method for detecting undervoltage fault for high voltage input for electric vehicles provided by the above-mentioned embodiments, whether the target component has the undervoltage fault can be accurately detected after the battery pack of the electric vehicle is powered on with the high voltage and before the target component is powered on with the high voltage. The method solves the problem in the prior art that the undervoltage fault for high voltage input for the target component can only be detected when the target component is in working state, which improves the convenience of electric vehicle management and maintenance and the user experience.

In one embodiment, after determining that the target component has an undervoltage fault for high voltage input, the method further includes outputting a prompt message that the target component has the undervoltage fault for high voltage input. Optionally, a prompting manner of the prompt message includes at least one of the following, text, voice, and light. For example, the prompt message can be output through text or light on components such as instrument panels or display screens of the electric vehicle, to inform users to check and solve faults in time, further improving the convenience of electric vehicle management and maintenance.

In one embodiment, the method further includes continuing to detect and determine whether the internal voltage of the target component is less than or equal to the preset voltage value after determining that the target component is powered on with the high voltage and enters a working state. Specifically, after the target component determines that the target component has completed the high voltage and enters the working state, the method can continue to obtain the internal voltage of the target component and determine whether the internal voltage of the target component is less than or equal to the preset voltage value. If the internal voltage of the target component is less than or equal to the preset voltage value, it can be determined that the target component has the undervoltage fault for high voltage input. In this way, the convenience of management and maintenance of the electric vehicle is further improved by cyclically detecting whether the target component has the undervoltage fault for high voltage input.

Based on the same inventive concept as the foregoing embodiments, this embodiment describes the technical solutions of the foregoing embodiments in detail through specific examples. In the present disclosure, the target component is a motor controller as an example for illustration.

Referring to FIG. 2, which is a schematic diagram of the structure of the existing electric vehicle high voltage system, including a power battery or a battery pack, a battery management system (BMS), a high voltage power distribution box, a motor controller (DCU), and an on-board charger (OBC) and a DC/DC power supply.

The power battery is used to store electric energy and provide high voltage power for high voltage components of the electric vehicle.

The main function of the battery management system is to manage battery packs and cells, including charge and discharge capabilities, thermal management, power on and off control, voltage/current acquisition and protection, etc.

The main function of the high voltage power distribution box is to distribute the high voltage and distribute the DC output from the battery pack to the high voltage components of the electric vehicle.

The main function of the motor controller is to control output torque of the motor and detect a high voltage input voltage of the motor controller.

The main function of the on-board charger is to convert AC 220V power into DC power, charge the battery pack, and check the OBC high voltage input voltage.

The main function of the DC/DC power supply is to convert high voltage direct current into low-voltage direct current, supply power to a low-voltage 12V system, and be responsible for detecting DC/DC high voltage input voltage.

Since the working premise of the electric vehicle is realized by providing high voltage power through the battery pack, before the electric vehicle can realize its function, the high voltage power on for the electric vehicle must first be completed. Referring to FIG. 3, it is a schematic diagram of the interactive flow of high voltage electricity on existing electric vehicle, which mainly includes the following processes:
1) Rotate an ignition key (Key) to the KEY-ON gear.
2) The vehicle controller (VCU) requests the BMS to close the main positive relay, namely Relay close, to turn on the high voltage circuit.
3) After receiving instructions from the vehicle controller, the BMS drives the main positive relay to close to power on the battery pack with the high voltage and sends closed state signal of the main positive relay and voltage value signal external the battery pack to the DCU and DC/DC respectively, the closed state signal is BMS_HVBattSt =online.
4) After the battery pack is powered on with high voltage, the high voltage components such as the motor controller and DC/DC detect a voltage value when inputting the high voltage to the high voltage components. If the detected voltage value is greater than a minimum voltage of the battery pack (such as 180V), the motor controller and DC/DC change to the working state, and feeds back to the vehicle controller. That is, the motor controller sends a DCU_ModeSt=ready signal to the vehicle controller, and the DC/DC sends a DCDCModeSt =ready signal to the vehicle controller.
5) The vehicle controller determines that the electric vehicle has completed the high voltage after receiving the signal that each high voltage component has completed high voltage and entered a work preparation state.

After the vehicle is powered on with high voltage, the motor controller and other high voltage components need to detect the high voltage input to ensure the safety of the high voltage circuit. When the motor controller and other high voltage components detects that the high voltage input is abnormal, the motor controller and other high voltage components will stop working, and light a fault light of a combination instrument, and record the fault codes. Then, the after-sales maintenance personnel read the fault codes through the after-sales diagnostic instrument to troubleshoot and solve the problem.

However, after the motor controller is woken up, the motor controller has ability to detect high voltage input. At this time, if the electric vehicle has not yet completed powered on with the high voltage, so the detection result must be undervoltage. If the undervoltage fault is reported at this time, the fault light of the combination instrument will be turned on and the fault codes will be recorded. The fault light and the fault codes will give customers and after-sales maintenance personnel a wrong instruction and reduce the quality of the vehicle. Therefore, the existing undervoltage fault detection is triggered after the high voltage components have powered on with the high voltage and are working normally.

Under the current strategy, if a high voltage fuse or a connector disconnection, or an internal circuit disconnection of the motor controller occurs before the motor controller enters the high voltage state, it is impossible to distinguish whether it is due to the input disconnection or the vehicle is not connected to high voltage, the undervoltage fault will not be reported. However, due to an actual occurrence of an input undervoltage fault, the electric vehicle cannot be driven after the customer starts the vehicle. The motor controller does not give a fault reminder on the instrument cluster, and the fault codes reported by the motor controller cannot be read when the vehicle is being repaired, cause the after-sales unable to locate faults, and quick repairs the fault.

In the present disclosure, the motor controller reads CAN signal of the high voltage state sent by the BMS to distinguish whether the electric vehicle is powered on with the high voltage to solve the above problems. The specific solution is as follows,
After receiving a Key on command, the vehicle controller will request the BMS to turn on the high voltage power.

The BMS will control the battery pack to power on with the high voltage and send a state of the main positive relay of the battery pack, and if the state of the main positive relay is a closed state means that the battery pack is power on with the high voltage.

The motor controller determines whether the electric vehicle has power on with the high voltage by receiving the state of the main positive relay of the battery pack (BMS_HVBattSt=online). To design redundancy, the motor controller will also read an actual voltage value external the main positive relay sent by the BMS after closing the main positive relay. If the actual voltage value is greater than a certain value (such as 180V), it means that the main positive relay is really closed, and high voltage is effective. When the above two conditions are met at the same time, it means that the electric vehicle has triggered the high voltage function, and the voltage value input by the motor controller should be valid. If the undervoltage is still detected at this time, it means that there must be a real undervoltage fault for high voltage input.

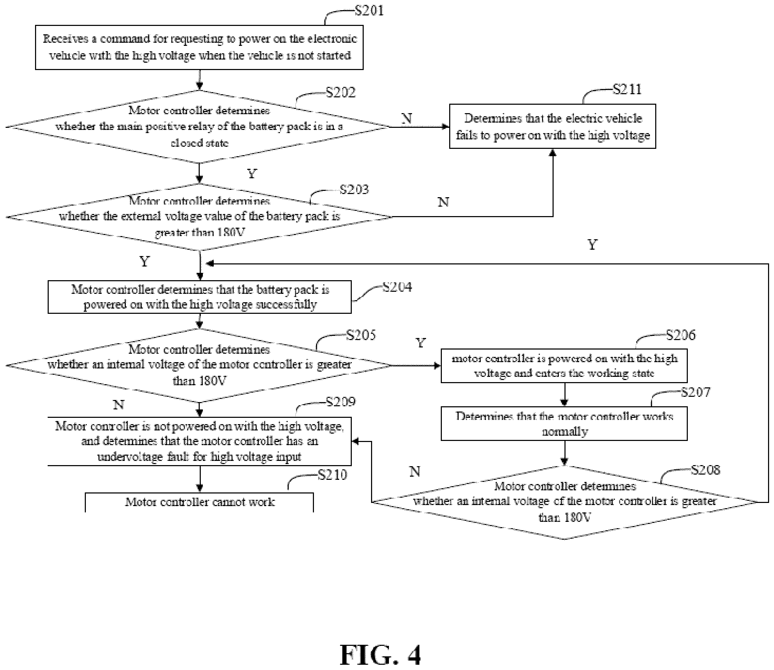

Referring to FIG. 4, FIG. 4 is a detailed flowchart of a high-voltage input under-voltage fault detection method for an electric vehicle provided by the present disclosure, the method includes the following Steps:
Step S201, receiving a command for requesting to power on the electronic vehicle with the high voltage when the vehicle is not started.

In one embodiment, the vehicle controller will request the BMS to turn on the high voltage power after receiving the Key on command, and the BMS will control the battery pack to complete the action of turning on the high voltage power, and send the motor controller the state of the main positive relay of the battery pack and a voltage external the battery pack.

Step S202, the motor controller determines whether the main positive relay of the battery pack is in a closed state. If so, then the method executes step S203, otherwise the method executes step S211.

Step S203, the motor controller determines whether the external voltage value of the battery pack is greater than 180V. If so, the method executes step S204, otherwise the method executes step S211.

In one embodiment, if the main positive relay of the battery pack is in the closed state, the motor controller continues to determine whether the external voltage value of the battery pack is greater than 180V.

Step S204, the motor controller determines that the battery pack is powered on with the high voltage successfully.

In one embodiment, if the main positive relay of the battery pack is in the closed state, and the motor controller continues to determine that the external voltage of the battery pack is greater than 180V, the motor controller determines that the battery pack is powered on with the high voltage successfully.

Step S205, the motor controller determines whether an internal voltage of the motor controller is greater than 180V. If so, then the method executes step S206, otherwise the method executes step S209.

In one embodiment, the motor controller determines whether the internal voltage is greater than 180V when the motor controller is not working.

Step S206, the motor controller is powered on with the high voltage and enters the working state.

Step S207, determining that the motor controller works normally.

Step S208, the motor controller determines whether the internal voltage is greater than 180V. If so, then the method executes step S204, otherwise the method executes step S209.

Step S209, the motor controller is not powered on with the high voltage, and determines that the motor controller has an undervoltage fault for high voltage input.

Step S210, the motor controller cannot work.

Step S211. determining that the electric vehicle fails to power on with the high voltage.

In one embodiment, if the main positive relay of the battery pack is not in the closed state, or the main positive relay of the battery pack is in the closed state, but the motor controller continues to determine that the external voltage reported by the battery pack is less than or equal to 180V, it is determined that the electric vehicle fails to power on with the high voltage.

Through the above scheme, the motor controller determines a state of the battery pack that whether the battery pack is powered on with the high voltage firstly, to identify whether the electric vehicle has triggered a power on demand, and then determines whether an undervoltage fault for high voltage input has occurred, so that the undervoltage fault can be truly and effectively detected. It can also make a reminder on the instrument, record the fault codes, and guide the after-sales personnel to repair the electric vehicle.

To sum up, in the method for detecting undervoltage fault for high voltage input for an electric vehicle provided by the above-mentioned embodiments, the method detects the undervoltage fault caused by an open circuit of the external circuit of the motor controller during the process that a high voltage battery pack of the vehicle is not electrified by a high voltage to the battery pack is powered on with the high voltage of the high voltage. The method improves the convenience of after-sales maintenance, can save maintenance costs, and can solve the aftermarket problem that the high voltage circuit is broken because the circuit fuse is blown, resulting in the failure of the motor controller and DC/DC to work without reporting the fault codes. The method further improves quality of the electric vehicle.

Based on the same inventive concept as the foregoing embodiments, the embodiment of the present disclosure provides a high-voltage input under-voltage fault detection device for an electric vehicle, as shown in FIG. 5. The device includes at least one processor 110 and a storage device 111 of the computer program running on the storage device 111. The processor 110 illustrated in FIG. 5 is not used to refer to the number of the processor 110 as one, but is only used to refer to the positional relationship of the processor 110 relative to other devices. In practical applications, the number of the processors 110 can be one or more. Similarly, the number of the storage device 111 illustrated in FIG 5 can be one or more. The processor 110 is configured to implement the method for detecting undervoltage fault for high voltage input for the electric vehicle when running the computer program.

The device may further include at least one network interface 112. Various components in the device are coupled together via a bus system 113. It can be understood that the bus system 113 is used to realize connection and communication between the various components. In addition to a data bus, the bus system 113 also includes a power bus, a control bus and a status signal bus. However, the various buses are labeled as bus system 113 in FIG. 5 for clarity of illustration.

In one embodiment, the storage device 111 may be a volatile memory or a non-volatile memory, and may also include both volatile and non-volatile memories. Among them, the non-volatile memory can be read-only memory (ROM), programmable read-only memory (PROM), erasable programmable read-only memory (EPROM), Only Memory), Electrically Erasable Programmable Read-Only Memory (EEPROM), Magnetic Random Access Memory (FRAM), Flash Memory (Flash Memory), Magnetic Surface Memory, CD, or Compact Disc Read-Only Memory (CD-ROM), magnetic surface storage can be disk storage or tape storage. The volatile memory may be Random Access Memory (RAM), which acts as an external cache. By way of illustration and not limitation, many forms of RAM are available such as Static Random Access Memory (SRAM), Synchronous Static Random Access Memory (SSRAM), Dynamic Random Access Memory (DRAM), Synchronous Dynamic Random Access Memory (SDRAM), Double Data Rate Synchronous Dynamic Random Access Memory (DDRSDRAM), enhanced Synchronous Dynamic Random Access Memory (ESDRAM), Synchronous Link Dynamic Random Access Memory (SLDRAM), Direct Memory Bus Random Access Memory (DRRAM). The storage device 111 described in the embodiments of the present disclosure is intended to include, but not be limited to, these and any other suitable types of memory.

The storage device 111 in the embodiment of the present disclosure is used to store various types of data to support the operation of the device. Examples of such data include: any computer programs used to operate on the device, such as operating systems and applications; contacts data; phonebook data; messages; pictures; videos, etc. Among them, the operating system includes various system programs, such as framework layer, core library layer, driver layer, etc., for realizing various basic services and processing tasks based on hardware. The application program may include various application programs, such as a media player (Media Player), a browser (Browser), etc., for implementing various application services. Here, the program for realizing the method of the embodiment of the present disclosure may be included in the application program.

Based on the same inventive concept as the foregoing embodiments, this embodiment also provides a computer storage medium, in which a computer program is stored, and the computer storage medium may be a magnetic random access memory (FRAM) , Read-Only Memory (ROM), Programmable Read-Only Memory (PROM), Erasable Programmable Read-Only Memory (EPROM), Electrically Erasable Programmable read-only memory (EEPROM), flash memory (Flash Memory), magnetic surface memory, optical disc, or CD-ROM (Compact Disc Read-Only Memory) and other memories; It may also be various devices including one or any combination of the above-mentioned memories, such as mobile phones, computers, tablet devices, personal digital assistants, and the like. When the computer program stored in the computer storage medium is run by the processor, the above-mentioned high voltage input undervoltage fault detection method of the electric vehicle is realized. Please refer to the description of the embodiment shown in FIG. 1 for the specific Steps and procedures implemented when the computer program is executed by the processor, and details are not repeated here.

The technical features of the above-mentioned embodiments can be combined arbitrarily. To make the description concise, all possible combinations of the technical features in the above-mentioned embodiments are not described. However, as long as there is no contradiction in the combination of these technical features, should be considered as within the scope of this specification.

In one embodiment, the terms "comprises", "includes" or any other variation thereof are intended to cover a non-exclusive inclusion of elements other than those listed and also other elements not expressly listed.

The above is only a specific embodiment of the present disclosure, but the scope of protection of the present disclosure is not limited thereto. Anyone skilled in the art can easily think of changes or substitutions within the technical scope disclosed in the present disclosure. Should be covered within the protection scope of the present disclosure. Therefore, the protection scope of the present disclosure should be determined by the protection scope of the claims.

## Claims

1. A high-voltage input under-voltage fault detection method for an electric vehicle, comprising:
obtaining an internal voltage of a target component of the electric vehicle after detecting that a battery pack of the electric vehicle is powered on with the high voltage and before the target component is powered on with the high voltage;
determining whether the internal voltage is less than or equal to a preset voltage value;
if yes, determining that the target component has the undervoltage fault for high voltage input.

2. The method according to claim 1, wherein before obtaining the internal voltage of the target component of the electric vehicle after detecting that the battery pack of the electric vehicle is powered on with the high voltage and before the target component is powered on with the high voltage, the method further comprises:
detecting whether the main positive relay of the battery pack is in a closed state;
if yes, determining that the battery pack of the electric vehicle is powered on with the high voltage; and
if no, determining that the battery pack of the electric vehicle is not powered on with the high voltage.

3. The method according to claim 2, wherein the detecting whether the main positive relay of the battery pack is in the closed state comprises:
receiving a state signal of the main positive relay of the battery pack sent by a battery management system; and
detecting whether the main positive relay of the battery pack is in the closed state according to the state signal.

4. The method according to claim 2, wherein before the determining that the battery pack of the electric vehicle is powered on with the high voltage, the method further comprises:
receiving an external voltage value of the battery pack sent by a battery management system;
detecting whether the external voltage value of the battery pack is greater than a preset voltage value;
if yes, performing a step of the determining that the battery pack of the electric vehicle is powered on with the high voltage; and
if no, performing a step of the determining that the battery pack of the electric vehicle is not powered on with the high voltage.

5. The method according to claim 1, wherein the obtaining the internal voltage of the target component of the electric vehicle comprises:
obtaining the internal voltage of the target component after detecting that the battery pack of the electric vehicle is power on with the high voltage for a preset period of time.

6. The method according to claim 1, wherein after determining that the target component has the undervoltage fault for high voltage input, the method further comprises:
outputting a prompt message that the target component has the undervoltage fault for high voltage input.

7. The method according to claim 6, wherein a prompting manner of the prompt message comprises at least one of text, voice, and light.

8. The method according to claim 1, wherein the method further comprising:
continuing to detect and determine whether the internal voltage of the target component is less than or equal to the preset voltage value after determining that the target component is powered on with the high voltage and enters a working state.

9. A high-voltage input under-voltage fault detection device for an electric vehicle, wherein the device comprises at least one process and a storage device for storing programs, the programs are used for executing steps of a high-voltage input under-voltage fault detection method for an electric vehicle as claimed in any one of claims 1-8 when the programs being executed by at least one processor.

10. A computer readable storage medium where computer programs are stored herein, the computer programs are used for executing steps of a high-voltage input under-voltage fault detection method for an electric vehicle as claimed in any one of claims 1-8 when the computer programs being executed by at least one processor.
